# EUROPEAN PATENT APPLICATION

(11) **EP 4 539 050 A2**
(43) Date of publication of application: **16.04.2025**
(21) Application number: 23315049.9
(22) Date of filing: 13.03.2023
(51) Int. Cl.: G11C 11/16, G11C 11/18

(54) **MAGNETIC MEMORY CELL BASED ON STT-ASSISTED SOT WRITING COMPRISING AN N-TYPE TRANSISTOR AND A P-TYPE TRANSISTOR AS SELECT TRANSISTORS, AND MRAM MEMORY**

(71) Applicant: Centre National de la Recherche Scientifique, 75016 Paris (FR)
(72) Inventor: Brecte, Victorien, 38240 MEYLAN (FR); Leroy, Fabien, 38240 MEYLAN (FR); Becle, Etienne, 38240 MEYLAN (FR); Louche, Julien, 38240 MEYLAN (FR); Bonnet, Charly, 38240 MEYLAN (FR); Sharma, Sulochna, 38240 MEYLAN (FR)
(74) Representative: IPAZ

(57) **Abstract**

An array of STT-assisted SOT-MRAM bit cells (CELL) each comprising a tri-layer element (TLE) including a ferromagnetic pinned layer, a ferromagnetic free layer, and a spacer interposed in-between, each of the STT-assisted SOT-MRAM bit cells (CELL) further comprising a SOT layer (SOT) adjacent to the ferromagnetic free layer and two select transistors (TrN, TrP), a first source line (SL) being, in the MRAM bit cell, connected to a second source line (SLB) through, in this order, a first one (TrN) of the two select transistors, the SOT layer (SOT), and a second one (TrP) of the two select transistors, the first one (TrN) and the second one (TrP) of the two select transistors being respectively an N-type transistor and a P-type transistor.

## Description

### FIELD OF THE INVENTION

The technical domain of the invention is that of Magnetoresistive Random Access Memory (MRAM) cells, that each comprise an element whose magnetic state defines a bit of information, and more specifically that of MRAM bit cells making use of a layer adjacent and parallel to this element to circulate a current in order to define its magnetic state.

### BACKGROUND OF THE INVENTION

Increased densities and reduction in die areas of embedded memories for cache applications, such as SRAM (Static Random Access Memory) and eDRAM (embedded Dynamic Random Access Memory) lead to increased static power consumption and reliability issues. Alternatives emerge such as MRAMs (Magnetoresistive Random Access Memory), that are scalable, power efficient and fast enough to replace existing memory technologies (SRAM) at cache levels.

MRAMs are devices able to store bits of data by means of magnetization state in tri-layer elements comprising a stack of two ferromagnetic layers separated by a non-magnetic spacer. When the spacer is conductive the tri-layer element is called a Spin Valve (SV) and when the spacer is insulating the tri-layer element is called a Magnetic Tunnel Junction (MTJ). The resistance of the tri-layer element (TLE)to electrical current passage is governed by quantum mechanical physics.

One of the two ferromagnetic layer has a pinned (or fixed) magnetization while the other one has a magnetization that can be oriented, and they are therefore often referred to as the pinned ferromagnetic layer (or fixed ferromagnetic layer, or also reference ferromagnetic layer) and the ferromagnetic free layer, respectively.

In an actual device, a tri-layer element (TLE) comprises other layers in addition to those cited so far, used to improve control over the physical properties of the device and/or inject currents therein and/or that are necessary for its manufacturing process.

A tri-layer element (TLE) exhibits two equilibrium states: a low-resistance state in which magnetizations of the two ferromagnetic layers are in a parallel state, i.e. magnetizations of both ferromagnetic layers are oriented towards a same direction, and a high-resistance state in which magnetizations of the two ferromagnetic layers are in an antiparallel state, i.e. magnetizations of the two ferromagnetic layers are respectively oriented towards two opposite directions.

An MRAM memory array comprises MRAM memory cells juxtaposed so as to form an array of rows and columns, each of the memory cells comprising a tri-layer element in which these two states and their corresponding electrical resistance values are associated to bit values, "0" or "1". These bit values are read by flowing an electrical current through the two ferroelectric layers of the tri-layer element (TLE) to determine its electrical resistance value, associated to a recorded bit value.

The ferromagnetic pinned layer is used as a reference ferromagnetic layer and its magnetization is stable over the lifetime of the device. The ferromagnetic free layer can be written (i.e. its magnetization orientation can be controlled) at will by application of a current or a magnetic field.

Regarding the write mechanism, one may cite three types of MRAMs each based on a specific mechanism for writing the state of the ferromagnetic free layer: Field switching MRAM relying of a magnetic field, Spin-Transfer Torque MRAM (STT-MRAM) relying on spin-transfer torque mechanism, and Spin Orbit Torque MRAM (SOT-MRAM) relying on spin orbit torque writing.

In any implementation, each MRAM memory cell of an MRAM array comprises at least one select transistor in order to select cells when writing and reading information by allowing current to flow in the cell.

A SOT-MRAM bit cell, where SOT stands for Spin Orbit Torque, is a three-terminal memory cell comprising typically at least one select transistor having a source or a drain connected to a SOT layer usually made of a heavy metal, adjacent to the free ferromagnetic layer of one tri layer element. The magnetization of the free ferromagnetic layer is controlled by circulating an electric current within the SOT layer by spin orbit torque interaction. In order to randomly select one memory cell of an MRAM array, two select transistors are needed, the SOT layer being connected in series with and between the respective channel regions of the two select transistors. Alternatively, a first transistor and a second transistor could be respectively connected to one side of the SOT layer and to the top of the MTJ.

However, cell density, i.e. the number of cells per any given surface area, is an important parameter for the design and fabrication of MRAM memories, a high density being highly desirable to optimize the use of resources such as factory machines and base materials. Using two select transistors to randomly select one memory cell of an MRAM array increases the area occupied by the SOT-MRAM bit cell, making it difficult to attain a high cell density.

M. Gupta, M. Perumkunnil, Kevin Garello, S. Rao, F. Yasin, et al. in "High-density SOT-MRAM technology and design specifications for the embedded domain at 5nm node", 2020 IEEE International Electron Devices Meeting (IEDM), Dec 2020, San Francisco, United States, pp.24.5.1-24.5.4, describe bit-cell architectures of SOT-MRAM technology and efforts relating to the size of the bit-cells.

### OBJECT OF THE INVENTION

In the context described above, the inventors propose to increase the density of MRAM bit cells making use of the spin orbit torque write mechanism by reducing the surface occupied by the select transistors of each cell, in a way that is made possible by controlling the state of the ferromagnetic layer of the cell by combining the writing of an SOT-MRAM with that of an STT-MRAM.

### SUMMARY OF THE INVENTION

To this effect, a first aspect of the invention relates to an array of STT-assisted SOT-MRAM bit cells each comprising a tri-layer element including a ferromagnetic pinned layer, a ferromagnetic free layer, and a spacer interposed in-between, each of the STT-assisted SOT-MRAM bit cells further comprising a SOT layer adjacent to the ferromagnetic free layer and two select transistors, a first source line being, in the MRAM bit cell, connected to a second source line through, in this order, a first one of the two select transistors, the SOT layer, and a second one of the two select transistors, the first one and the second one of the two select transistors being respectively an N-type transistor and a P-type transistor.

Advantageously, such an MRAM bit cell array allows a reduced footprint by optimizing simultaneously the gate-source voltages of each of the two select transistors and thus reducing the necessary surface to pe occupied by each of these transistors.

Further, the capacitance of the source, the drain and the gate of the bit cell transistors are reduced, which improves the speed and the energy consumption of the array.

According to further non limitative features of the first aspect of the invention, either taken alone or in any technically feasible combination:
- for each of the bit cells, the ferromagnetic pinned layer and the ferromagnetic free layer can each present a perpendicular magnetic anisotropy;
- the array can be configured to write a magnetic state of the ferromagnetic free layers by STT-assisted SOT writing;
- for each of the bit cells, the tri-layer element can be a magnetic tunnel junction;
- for each of the bit cells, the tri-layer element can be a spin valve; and
- each of the bit cells further can comprise a first word line and a second word line, respectively connected to a gate electrode of the first one and the second one of the two select transistors, the first word line being distinct from the second word line.

A second aspect of the invention relates to an MRAM memory comprising at least the array according to the invention, a first word line driver functionally connected to the first word line so as to drive the first one of the two select transistors of bit cells belonging to a same row of bit cells of the array, and a second word line driver functionally connected to the second word line so as to drive the second one of the two select transistors of the bit cells belonging to the same row of bit cells of the array.

According to further non limitative features of the second aspect of the invention, either taken alone or in any technically feasible combination:
- the first word line driver can be configured to drive the first one of the two select transistors by applying a high electrical potential to the first word line, and the second word line driver can be configured to drive the second one of the two select transistors by applying a low electrical potential to the second word line, the low electrical potential being lower than the high electrical potential;
- the first word line driver and the second word line driver can be configured to apply simultaneously the high electrical potential and the low electrical potential respectively to the first word line and to the second word line to select at least one of the bit cells of the array;
- the MRAM memory according to the invention can further comprise a bit line driver and a source line driver, the bit line driver, the source line driver, the first word line driver and the second word line driver can be configured to, during a writing operation of a given one of the bit cells, circulate a writing current between the first source line and the second source line through the channels of the two select transistors and through the SOT line, and circulate a write-assisting current through the ferromagnetic pinned layer, the spacer and the ferromagnetic free layer of the tri-layer element, thereby writing a magnetic state of the ferromagnetic free layer;
- two transistors of a same type of two bit cells belonging to two consecutive columns and to the same row of the array can share a same gate electrode;
- four transistors of a same type of four bit cells belonging to four consecutive columns and to the same row of the array can share a same gate electrode;
- a same gate electrode can cross four regions each implanted with ions so as to form the source, drain and channel regions of four transistors of a same type; and
- each of the bit cells can comprise a plurality of tri-layer elements each connected between a respective bit line and the SOT layer.

A third aspect of the invention relates to an integrated electronic circuit including the MRAM memory according to the invention.

Further to the previously cited advantages, the geometry of the array allows to even more reduce the footprint of the memory by minimizing loss of space on the semiconductor substrate on which are formed the MRAM bit cells.

### FIGURES

Many other features and advantages of the present invention will become apparent from reading the following detailed description, when considered in conjunction with the accompanying drawings, in which:
- Figure 1 illustrates a core of an MRAM bit cell ;
- Figure 2 illustrates a integration of the core of figure 1 into an STT-assisted SOT-MRAM bit cell ;
- Figure 3 illustrates an operation of the bit cell of figure 2 ;
- Figure 4 illustrates a memory including an array of the bit cell of figure 2 ;
- Figure 5 illustrates a first implementation of the array of figure 4 ;
- Figure 6 illustrates a second implementation of the array of figure 4 ;
- Figure 7 illustrates electronic circuits including the memory of figure 4 ;
- Figure 8 illustrates a comparative example; and
- Figure 9 illustrates a variation to the structure illustrated by Figure 2.

The figures are schematic representations that, for the sake of clarity, are not drawn to scale and, in particular, thicknesses of layers are not to scale compared to lateral dimensions.

### DETAILED DESCRIPTION OF A SPECIFIC EMBODIMENT OF THE INVENTION

An STT-assisted SOT-MRAM bit cell according to the invention has the overall structure of an SOT-MRAM bit cell, with a tri-layer element TLE controlled by means of three electric terminals.

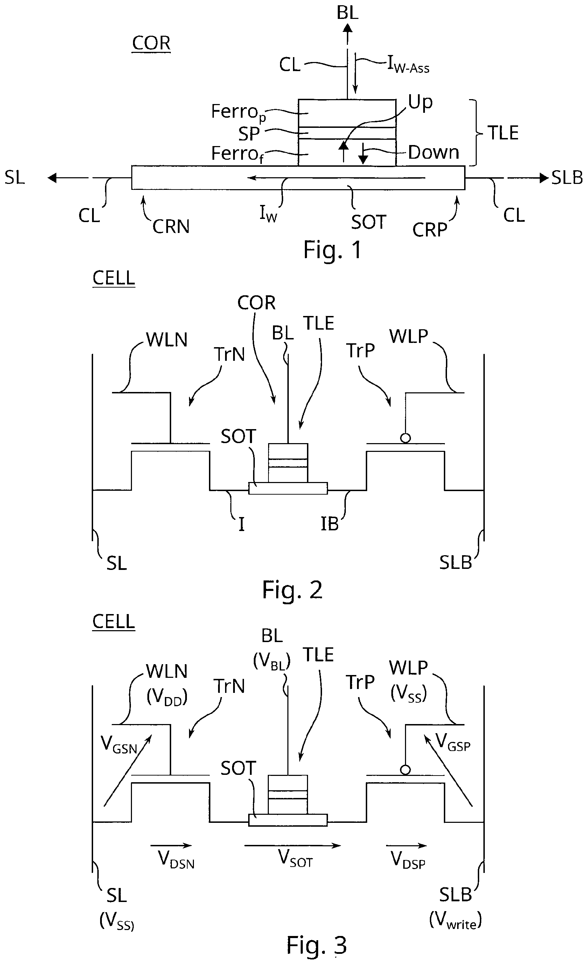

Figure 1 illustrates the core COR of the cell: a tri-layer element TLE comprising a ferromagnetic free layer Ferro_{f} and a pinned ferromagnetic layer Ferroₚ separated by a spacer SP, and a SOT layer SOT adjacent to the ferromagnetic free layer, this layer SOT being configured to generate a spin-orbit torque onto the spins of the free ferromagnetic layer upon circulation therein of a write current Iw. A write-assisting current, of either positive or negative value, can be injected into the tri-layer element via the pinned ferromagnetic layer Ferroₚ.

The ferromagnetic layers Ferro_{f} and Ferroₚ both present a perpendicular magnetic anisotropy (PMA), which means that their spins are naturally aligned along a direction perpendicular to the planes of extension of these layers. In contrast, "in-plane" directions refer to directions that are parallel to the extension planes of the ferromagnetic layers Ferroₚ and Ferro_{f}, i.e. normal to the natural orientation of the spins the ferromagnetic layers Ferro_{f} and Ferroₚ. The magnetic state of the tri-layer element can be parallel (the magnetizations of the two ferromagnetic layers have a same direction) or anti-parallel (the magnetizations of the two ferromagnetic layers have opposite directions).

As illustrated in Fig. 1, in a SOT-MRAM bit cell, two opposite contact regions CRN and CRP of the SOT layer are respectively connected to a first source line SL and a second source line SLB via two electrically conductive lines CL, the write-assisting current I_{W-Ass} being injected into the pinned ferromagnetic layer Ferroₚ originating from a bit line BL via a third electrically conductive line CL. The two opposite contact regions of the SOT layer can be two opposite extremities of the SOT-layer. In any event, the two opposite contact regions are localized so that a current passing through these two contact regions passes in a contact region of the SOT layer immediately adjacent to the free ferromagnetic layer and between the two opposite contact regions, so as to control the magnetic state of Ferroε by spin-orbit torque mechanism. The write current I_{W} circulates between the source lines SL and SLB.

In a memory cell according to the present embodiment, the write operation of the magnetic state of the free ferromagnetic layer Ferro_{f} is performed by STT-assisted SOT writing: the write current Iw passing through the layer SOT brings the magnetization in an in-plane direction by spin-orbit torque (SOT) interaction, and the write-assisting current I_{W-Ass} current forces the direction of the magnetization into a direction perpendicular to the plane of extension of the ferromagnetic free layer by spin-transfer torque (STT) interaction, one of two opposite directions Up and Down depending on the direction of the write-assisting current I_{W-Ass}, as illustrated in figure 1. In effect, the magnetic state of tri-layer element can be transitioned between the parallel and the anti-parallel states of the tri-layer element. The patent document EP 3 671 749 B1 explains in more details the operation of STT-assisted SOT writing.

Otherwise stated, the magnetic state of the free ferromagnetic layer is not imposed by the direction of the write current Iw passing through the SOT layer as is done in a purely SOT-MRAM bit cell, but by the direction of the write-assisting current I_{W-Ass} passing through the tri-layer element. As will become apparent in the following, this characteristic makes it possible to optimize the cell architecture.

Figure 2 illustrates an integration of the core COR into an STT-assisted SOT-MRAM bit cell CELL according to the invention, including select transistors and lines employed to address and control the MRAM bit cell and the magnetic state of the free ferromagnetic layer Ferro_{f}.

The bit line BL is connected to the pinned ferroelectric layer Ferroₚ of the tri-layer element. During a write operation, the two select transistors are turned on, a voltage applied to the bit line BL determines the state of the ferroelectric free layer Ferroε to be written by determining the value and the direction of the current I_{W-Ass}. It may be a high voltage V_{BL} or a low voltage V_{SS}, depending on the bit value of the data to store. The bit line BL will also be of use, in a conventional manner, to read the magnetic state of the free ferromagnetic layer Ferroε.

The first contact region of the SOT layer is connected to a source line SL through the channel a first select transistor TrN that is a transistor of N-type. The first contact region of the SOT layer is connected to one of a source and a drain of the transistor TrN via a first node I. The second contact region of the SOT layer is connected to a second source line SLB through the channel of a second select transistor TrP that is a transistor of P-type. The second contact region of the SOT layer is connected to one of a source and a drain of the transistor TrP via a second node IB.

The transistor TrN comprises a gate. The MRAM bit cell is configured so that a state of the transistor TrN is controlled by application of a first voltage to this gate via a first word line WLN.

The transistor TrP comprises a gate. The MRAM bit cell is configured so that a state of the transistor TrP is controlled by application of a second voltage to this gate via a second word line WLP.

The MRAM bit cell is configured so that currents can be sent through the tri layer element TLE via the bit line BL, connected to the ferromagnetic pinned layer Ferroₚ.

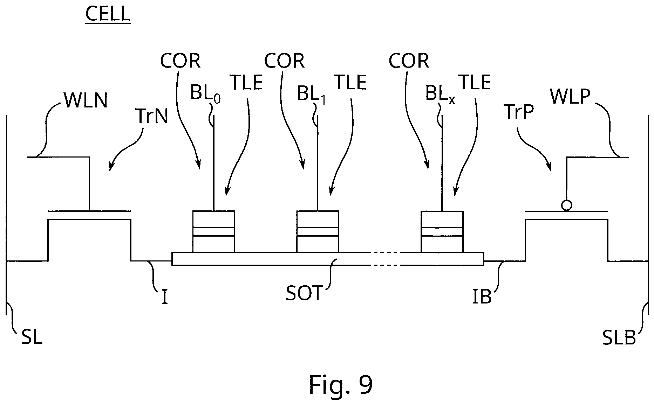

Figure 9 illustrates a variant of the structure illustrated by Figure 2, in which a bit cell comprises more than one core COR each comprising a tri-layer element TLE formed in contact with the SOT layer and in electrical contact with a respective bit line, bit lines BL₀, BL₁ and BLₓ in Figure 9. The SOT line may be formed continuously or may comprise a plurality of SOT sections electrically connected in series, each of the tri-layer elements being formed in contact with one of the SOT sections.

Figure 3 illustrates the operation of the MRAM bit cell.

During a write operation of the MRAM-cell illustrated by figure 2, a low electrical potential V_{SS} is applied to the lines SL and WLP, while high electrical potentials V_{DD} and V_{write} are respectively applied to the lines WLN and SLB. As their designations imply, the high potentials are higher than the low potential. The high potential V_{write} is chosen so as to insure that the write current Iw running the SOT layer is above a threshold current I_{Th} sufficient to influence the magnetic state of the free ferromagnetic layer Ferroε so as to allow operation of the STT-assisted SOT-MRAM. Conversely, the high potential V_{write} is also chosen low enough to not damage the SOT line, for example by electromigration, depending on the thickness and the material of the SOT line.

As a consequence, a first gate-source voltage V_{GSN} is applied to the gate of the transistor TrN and a second gate-source voltage V_{GSP} is applied to the gate of the transistor TrP, with V_{GSN} = V_{DD}-V_{SS} et V_{GSN} = V_{SS}-V_{write}.

Both of the two gate source-potentials can have a value adequate to make the corresponding two transistors driven with high "on" states, meaning that each of the two transistors will present a low resistance to current circulating between the source lines SL and SLB through their two channels and the SOT layer. In this manner, the source-drain voltages V_{DSN} and V_{DSP} of the transistors are minimized and the voltage V_{SOT} applied to the two contact regions of the SOT layer is maximized, being as close as possible to the maximum value (V_{write}-V_{SS}), and the write current Iw is thus maximized as well. This effect is notably achieved by the use of two transistors of different types, N-type and P-type, a configuration that allows maximizing simultaneously the two gate-source voltages.

Since the functioning of the active elements of the MRAM memory cell is optimized, the driving of the cell can be done with transistors of a size just adapted for a target value for the write current Iw, which means a reduced size and an increased density of the MRAM-cell array. In contrast, a non-optimized functioning needs to be made up for with transistors of increased dimensions for them to be able to drive the target value of the write current I_{W}.

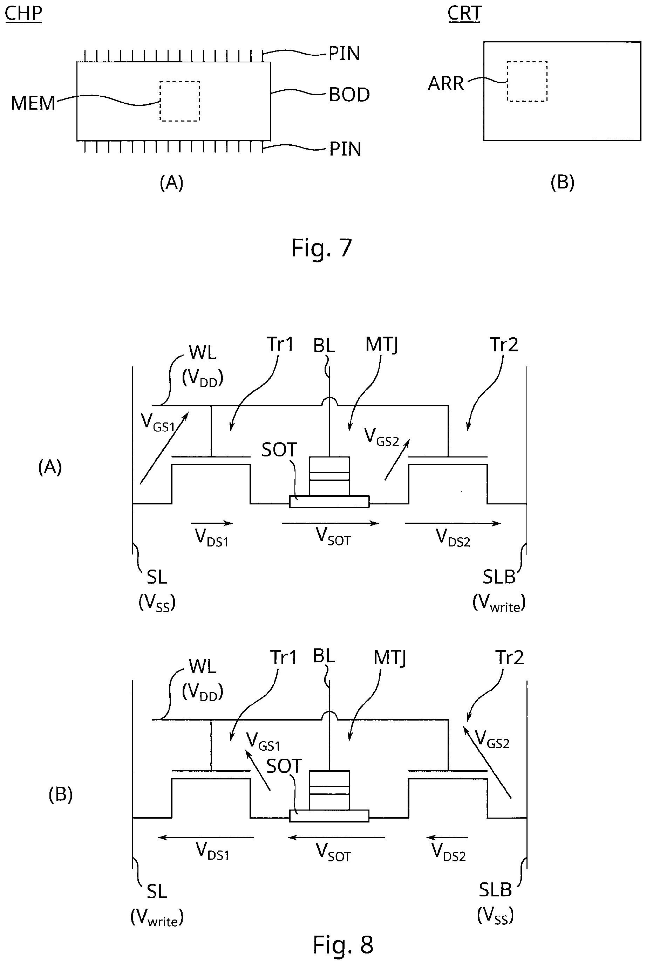

Unlike a conventional SOT-RAM comprising two select transistors of a same type (see the comparative example below, illustrated by figure 8), two transistors of opposite types are used in the STT-assisted SOT-MRAM according to the invention, which requires to apply two signals of opposite voltages to select any given cell of an array, and thus two distinct word lines, the word line WLN and the word line WLP.

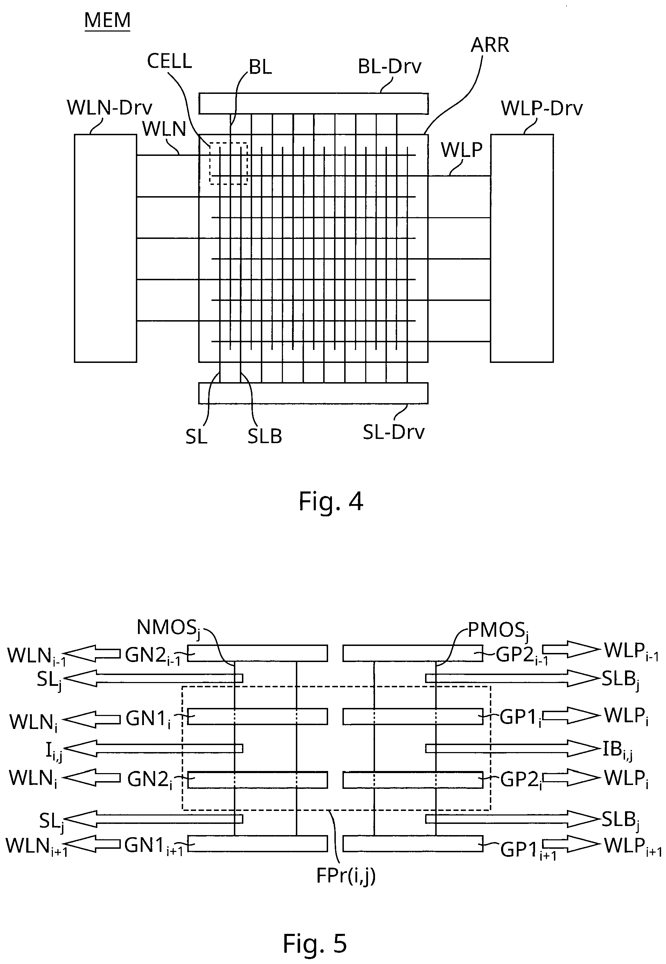

Figure 4 illustrates an STT-assisted SOT-MRAM MEM that comprises drivers (WLN-Drv, WLP-Drv, BL-Drv, SL-Drv) configured to control an array ARR comprising a plurality of MRAM bit cells CELL forming rows and columns of the array, each cell having the structure of the cell CELL described in relation to figures 2 and 3 and configured to be written by STT-assisted SOT writing. Each of the word lines WLN and WLP is dedicated to a given one of the rows and are shared by each of the cells forming this row, while each line SL, SLB and BL is dedicated to a given one of the columns and is shared by each of the cells forming this column. The array is connected to electronic circuits situated at the periphery of the array through the lines. Among these circuits are two word line drivers: a first word line driver WLN-Drv configured to drive the word lines WLN by selectively applying a high electrical potential to the lines WLN, and a second word line driver WLP-Drv configured to drive the word lines WLP by selectively applying a low electrical potential to the word lines WLP, both potentials being applied simultaneously to the cells of a given row, and the low electrical potential being lower than the high electrical potential. A bit line driver BL-Drv is configured to control potentials (V_{BL} or V_{SS}) applied to each of the bit lines BL or let them floating. A source line driver SL-Drv is configured to control potentials respectively applied to the source lines SL and SLB or let them floating.

The drivers of the STT-assisted SOT-MRAM are configured to be used in conjunction to perform reading and writing operations on the bit cells forming the array ARR.

For a write operation of a given one of the MRAM bit cells, the drivers are electronic circuits configured to control the potentials of the associated lines (WLN, WLP, BL, SL, SLB) so as to turn simultaneously the two select transistors into an "on" state, circulate the writing current Iw between the lines SLB and SL through the channels of the two select transistors and through the SOT line, and circulate the write-assisting current I_{W-Ass} through the three layers (Ferroₚ, SP and Ferro_{f}) of the tri-layer element, thereby writing a magnetic state of the free ferromagnetic layer depending on the orientation of the write-assisting current I_{W-Ass}. The drivers determine the orientation of the write-assisting current I_{W-Ass} in a conventional manner by controlling the electrical potentials applied to the lines. The table Tab. 1 below lists the potentials applied to the lines for any given bit cell during a write operation.

**Tab. 1**

| **Operation** | **Bit cell** | **WLP** | **WLN** | **SL** | **SLB** | **BL** |
|---|---|---|---|---|---|---|
| **Write** | Selected | V_{SS} | V_{DD} | Vss | Vwrite | V_{BL} or V_{SS} |
| **Write** | Unselected | V_{DD} | V_{SS} | V_{SS}/HiZ/V_{DD} | V_{SS}/HiZ/V_{DD} | V_{SS}/HiZ/V_{DD} |
| **Write** | Row selected, not column | V_{SS} | V_{DD} | VSS/HiZ/V_{DD} | V_{SS}/HiZ/V_{DD} | V_{SS}/HiZ/V_{DD} |
| **Write** | Column selected, not row | V_{DD} | V_{SS} | V_{SS} | Vwrite | V_{BL} or V_{SS} |

For a read operation, the driver are configured to control the potentials of the associated lines (WLN, WLP, BT, SL, SLB) so as to turn "on" at least one of the two transistors, put the two source lines at a low potential and the bit line at a read potential V_{read}, low enough to avoid damaging the MTJ and high enough to ensure a good reading of the state of the MTJ. The bit line driver is further configured to detect a current running through the bit line and compare this current to a reference current. Depending on the result of the comparison, it is determined whether the ferromagnetic layers Ferroₚ and Ferro_{f} are in a parallel or an antiparallel state, and therefore if a "0" or a "1" bit value is recorded in the bit cell CELL. The table Tab. 2 below lists the potentials applied to the lines for any given bit cell during a write operation.

**Tab. 2**

| **Operation** | **Bit cell** | **WLP** | **WLN** | **SL** | **SLB** | **BL** |
|---|---|---|---|---|---|---|
| **Read** | Selected | V_{SS} | V_{DD} | V_{SS} | V_{SS} | Vread |
| **Read** | Deselected | V_{DD} | V_{SS} | V_{SS}/HiZ/V_{DD} | V_{SS}/HiZ/V_{DD} | V_{SS}/HiZ/V_{DD} |
| **Read** | Row selected, not column | V_{SS} | V_{DD} | V_{SS}/HiZ | V_{SS}/HiZ | V_{SS}/HiZ |
| **Read** | Column selected, not row | V_{DD} | V_{SS} | V_{SS} | V_{SS} | Vread |

The values V_{SS}, V_{DD}, Vwrite and V_{BL} mentioned in the tables have been defined previously. HiZ defines a state in which no transistor in the "on", or conducting, state is connected to the concerned line. An alternative V_{SS}/HiZ/V_{DD} means that either a potential Vss or a potential V_{DD} may be applied, with the advantage of a high operation speed, or alternatively that the line may be floating in a state HiZ of high impedance, with the advantage of a lower energy consumption.

For explanation purposes, read and write operations have been described based on the use of conventional nominal low and high voltages V_{SS} and V_{DD}. However, the operations of the array are not limited to these voltages. It is for example possible to drive the word lines WLN with a voltage higher than nominal high voltage to drive more current in the bit cell transistors TrN, and to drive the word lines WLN with a voltage lower than nominal low voltage to reduce the current leakage when these transistors are "off". Conversely, it also possible to drive the word lines WLP with a voltage lower than nominal low voltage to drive more current in the bit cell transistors TrP, and to drive the word lines WLN with a voltage higher than nominal high voltage to reduce the current leakage when these transistors are "off".

In the case where more than one core is comprised in each bit cell, as illustrated by Figure 9, each core may be selectively unselected by application of a specific voltage Vᵤₙₛₗ defined to limit parasitic currents, or by being put at the state HiZ.

Figure 5 illustrates a first implementation of the STT-assisted SOT-MRAM bit cell array illustrated by figures 1 to 4. Figure 5 represents a top view of one cell CELL(i,j) belonging to a j^{th} column of cells, and to an i^{th} row of cells between an (i-1)^{th} row and an (i+1)^{th} row, and parts of the cells belonging to the (i-1)^{th} row and the (i+1)^{th} row, i and j being positive integers. Indicia "i", "i-1", "i+1" and "j" indicate the rows and columns to which belong the illustrated elements, the i^{th} row, the (i-1)^{th} row, the (i+1)^{th} row and the j^{th} column, respectively. Although not represented, the SOT layer of a given cell belonging to the i^{th} row and the j^{th} column connects the node I_{i,j} to the node IB_{i,j}. The indicia "i-1", "i" and "i+1" refers to consecutive rows of cells disposed in this order and description of a cell of the i^{th} row applies to the cells of the " (i-1)^{th} row and the (i+1)^{th} row.

The transistor TrN of CELL(i,j) is in fact implemented as two physical transistors with each their own gate electrode, respectively GN1 and GN2, more specifically GN1ᵢ and GN2ᵢ for the transistor TrN of the i^{th} row, both connected to a same word line WLNᵢ. The gate electrodes GN1ᵢ and GN2ᵢ are formed over a region NMOSⱼ of a semiconductor substrate that has been implanted with ions so as to form the source, drain and channel regions of the N-type transistor TrN of the j^{th} column of the array.

Similarly, the transistor TrP of CELL(i,j) is in fact implemented as two physical transistors with each their own gate electrode, respectively GP1 and GP2 (GP1ᵢ and GP2ᵢ for the transistor TrP of the i^{th} row), both connected to a same word line WLPᵢ. The gate electrodes GP1ᵢ and GP2ᵢ are formed over a region PMOS of the semiconductor substrate that has been implanted with ions so as to form the source, drain and channel regions of the P-type transistor TrP of the j^{th} column of the array. The connections between the lines and nodes of Figure 2 to the regions of the semiconductor substrate and the gate electrodes of Figure 4 are indicated by hollow arrows on Figure 4 and described hereunder.

For a cell of the i^{th} row and the j^{th} column, node I_{i,j} is connected to a portion of the region NMOSⱼ located between the gate electrodes GN1ᵢ and GN2ᵢ; the line SLⱼ is connected to a first portion of the region NMOSⱼ located between the gate electrodes GN1ᵢ and GN2ᵢ₋₁ and to a second portion of the region NMOS located between the gate electrodes GN2ᵢ and GN1ᵢ₊₁.

Similarly, for the cell CELL(i,j) of the i^{th} row and the j^{th} column, node IB_{i,j} is connected to a portion of the region PMOSⱼ located between the gate electrodes GP1ᵢ and GP2ᵢ; the line SLBⱼ is connected to a first portion of the region PMOSⱼ located between the gate electrodes GP1ᵢ and GP2ᵢ₋₁ and to a second portion of the region PMOS located between the gate electrodes GP2ᵢ and GP1ᵢ₊₁.

The connections are realized through electrically conductive layers separated by electrically insulating layer and through electrically conductive vias connecting the conducting layers to each other or to the gate electrodes or portions of the NMOS or PMOS regions of the semiconductor substrate. The footprint FPr(i,j) of one cell at the intersection of the row i and the column j of the array is visualized as a dotted rectangle in figure 5.

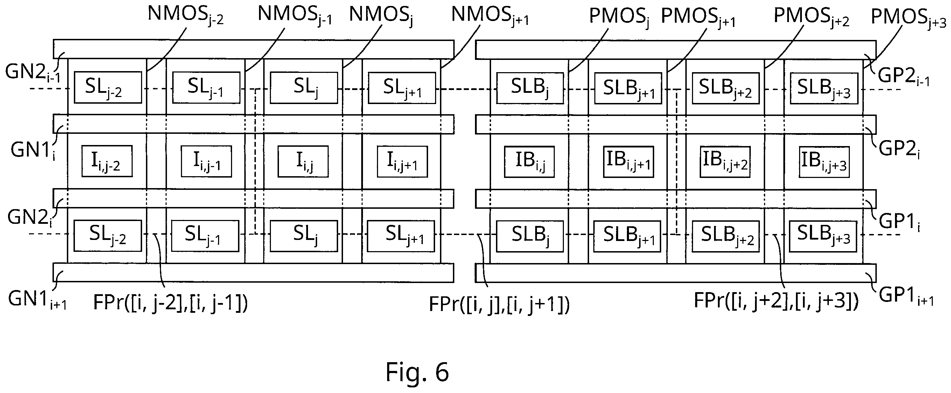

Figure 6 illustrates a second implementation of the STT-assisted SOT-MRAM bit cell array illustrated by figures 1 to 4, with a portion of an array of such cells.

Compared to the first implementation of figure 5, transistors of a same type of a pair of adjacent cells belonging to a same row of cells (i.e. controlled by the same word lines) are grouped together to share one gate contact, which allows further reducing the footprint of a single bit cell. In the example of Figure 6, transistors of bit cells belonging to a same row i and to two consecutive columns j and j+1 are grouped so that N-type transistors are formed in adjacent regions NMOSⱼ and NMOSⱼ₊₁ each implanted with ions so as to form the source, drain and channel regions of an N-type transistor, P-type transistors are formed in adjacent regions PMOSⱼ and PMOSⱼ₊₁ implanted with ions so as to form the source, drain and channel regions of a P-type transistor, the indicia indicating the considered columns, the same notation as for the rows being used, j being a positive integer. In effect, the columns of bit cells are intertwined by pairs.

In addition, the gates of a given type of transistors belonging to a same row i and to the pair of columns j and j+1 share a gate electrode and thus a gate contact with the transistors of the same type belonging to next two columns j+2 and j+3. Figure 6 illustrates gates GP1ᵢ and GP2ᵢ each crossing the four regions PMOSⱼ to PMOSⱼ₊₃ each implanted with ions so as to form the source, drain and channel regions of a P-type transistor, that are consecutively located in the row direction, without intervening NMOS region. This feature also allows reducing the footprint of a single bit cell. In contrast, in the structure illustrated by Figure 5, two consecutive regions of a same type of transistors would be separated by a region of a transistor of the other type, which requires more space for the additional gate contacts, to separate two transistors of different types, and also spaces separating word lines WLNᵢ and WLPᵢ of the i^{th} row.

The footprints FPr([i,j], [i,j+1]) of two grouped cells of the array is visualized as a dotted rectangle in Figure 6, and represent the area occupied on a semiconductor substrate by the bit cells of the i^{th} row and the j^{th} and (j+1)^{th} columns. Only half of the footprints FPr([i,j-2],[i,j-1]) of the area occupied by the bit cells of the i^{th} row and the (j-2)^{th} and (j-1)^{th} columns is represented. Similarly, only half of the footprints FPr([i,j+2], [i,j+3]) of the area occupied by the bit cells of the i^{th} row and the (j+2)^{th} and (j+3)^{th} columns is represented. In Figure 6, the elements to which the portions of semiconductor are connected are indicated in rectangles situated directly on the portions to which they are connected, respectively. For example, the portion of the PMOS region PMOSⱼ comprised between the gate electrodes GP1i and GP2i is connected to the node IB of the bit cell located at the i^{th} row and the j^{th} column of the array ARR. The rectangle may represent electrical contact formed in an insulating layer covering the semiconductor substrate on which the transistors of the bit cells are formed.

Figure 7 illustrates at (A) a standalone memory chip CHP including an STT-assisted SOT MRAM memory MEM as an integrated circuit including the MRAM bit cell array ARR of figure 4 encapsulated within a body BOD along with associated driver (at least one circuit for each of the lines SL, SLB, WL, WLB and BL), a plurality of connecting pins PIN fixed to the body allowing functional access to the MRAM bit cell array ARR from the outside of the body.

Figure 7 illustrates at (B) an integrated electronic circuit CRT, such as an ASIC circuit, integrating the MRAM bit cell array MEM of figure 4.

In any of the examples above, the lines SL, SLB, BL, WLN, and WLP and the nodes I and IB can be made of materials conventionally used in the field, such as aluminum or copper, and the transistors TrN and TrP can be conventional MOSFET transistors.

The SOT layer SOT can comprises a SOT material, where the SOT material can include an electrically conductive material such as Pt, W, Ir, Ru, Pd, Cu, Au, Bi, Hf, Se, Sb or of an alloy of these elements, or is formed of a stack of a plurality of layers of each of these metals. SOT layer SOT can also be made from an antiferromagnetic material such as alloys with a base of Mn such as IrMn, FeMn, PtMn, or alloys of these compounds such as PtFeMn. Alternatively, the SOT layer SOT can be made from a ferromagnetic material, such as Fe, Co, Ni or of an alloy of these elements. Still alternatively, SOT layer SOT can be made from a topological insulator, such as bismuth-based topological insulators or antimony chalcogenide based topological insulators (Bi₂Se₃, Bi₂Te₃, Sb₂Te₃ or Bi₁₋ₓSbₓ, Bi_{1.1}Sb_{0.9}Te₂S etc...), because the SOT layer can be very thin. SOT layer SOT has a thickness comprised between 0.5 nm and 200 nm, preferably between 0.5 and 10 nm, more preferably between 0.5 nm and 5 nm.

Ferroelectric layers Ferro_{f} and Ferroₚ can comprise a ferromagnetic material including a metal or alloy having a specific perpendicular magnetic anisotropy whereby magnetizations of these layers are oriented substantially vertically (perpendicular to the plane of the ferromagnetic layers, configuration known as out-of-plane or perpendicular magnetic anisotropy PMA). Such metal or alloy can comprise FePt, FePd, CoPt, or a rare earth/transition metal alloy, in particular GdCo, TdFeCo, or Co, Fe, CoFe, Ni, CoNi, CoFeB, FeB. The thickness of the ferromagnetic layers Ferro_{f} and Ferroₚ can be comprised between 0.5 nm and 10 nm and preferably between 1 and 3 nm.

When the tri-layer element LTE is a magnetic tunnel junction, the spacer SP is a tunnel insulating layer that can include a dielectric material such as MgO or Al₂O₃. When the tri-layer element LTE is a spin valve, the spacer SP can include a non-magnetic electrically conductive material such as copper or cobalt.

### Comparative example

Figure 8 illustrates the operation of a conventional SOT-MRAM bit cell having a same structure as that illustrated by figures 2 and 3, except that the two select transistors Tr1 and Tr2 are both transistors of N-type that are controlled by a same word line WL.

The structure of a conventional SOT-MRAM bit cell comprises a symmetry-breaking means, such as an internal or an external electric or magnetic field, or specific materials or shape. With the assistance of the symmetry-breaking means, the write operation of such a conventional SOT-MRAM bit cell is based on spin-orbit torque principle, which implies that the orientation of the write current Iw, circulating between the lines SL and SLB, determines the magnetic state of the free ferromagnetic layer.

In (A), figure 8 illustrates a write operation of a first state of the free ferromagnetic layer, corresponding to one of the "0" and "1" bit value for this MRAM-cell, in which a low electrical potential Vss is applied to the line SL, a high electrical potential is applied to the word line WL, and a write (positive) potential V_{write} is applied to the line SLB.

The source-gate voltage V_{GS1} of the first transistor has a value (V_{DD}-V_{SS}) that allows a relatively high "on" state for this transistor, allowing a relatively high current to pass. In contrast, due to the source-drain voltage V_{DS1} of the first transistor and the voltage V_{SOT} between the two contact regions of the SOT layer, the source-gate voltage V_{GS2} of the second transistor has a value (V_{DD}-V_{SS}-V_{SOT}-V_{DS1}) lower than the source-gate voltage V_{GS1} of the first transistor, preventing the second transistor to let pass a same amount of current as the first transistor, introducing a high resistance on the path of the write current I_{W}.

In (B), figure 8 illustrates a write operation of a second state of the free ferromagnetic layer, corresponding to the other of the "0" and "1" bit value for the MRAM-cell, in which a low electrical potential V_{SS} is applied to the line SLB, a high electrical potential is applied to the word line WL, and a write (positive) potential V_{write} is applied to the line SL.

The source-gate voltage V_{GS2} of the second transistor has a value (V_{DD}-V_{SS}) that allows a relatively high "on" state for this transistor, allowing a relatively high current to pass. In contrast, due to the source-drain voltage V_{DS2} of the second transistor and the voltage V_{SOT} between the two contact regions of the SOT layer, the source-gate voltage V_{GS1} of the first transistor has a value (V_{DD}-V_{SS}-V_{SOT}-V_{DS1}) lower than the source-gate voltage V_{GS2} of the second transistor, preventing the first transistor to enter in the relatively high "on" state, introducing a high resistance on the path of the write current Iw.

As detailed above, since the architecture of the conventional SOT-MRAM is symmetrical, there will always be one of the two select transistors that will have a low gate-source voltage. This will induce a high resistance for this transistor, and will have to be compensated by an increased width of the gate electrodes of the two select transistors to increase intensity of the write current Iw regardless of the bit value, "0" or "1", to be written. As a consequence, the area occupied by the cell is increased as well, reducing the density of the MRAM bit cell array.

Each of the examples mentioned in this document can be freely combined within technical limits understood by the practitioner in the field of the invention.

Other variations to the disclosed embodiments can be understood and effected by those skilled in the art in practicing the claimed invention, from a study of the drawings, the disclosure, and the appended claims.

## Claims

**1.** An array (ARR) of STT-assisted SOT-MRAM bit cells (CELL) each comprising a tri-layer element (TLE) including a ferromagnetic pinned layer (Ferroₚ), a ferromagnetic free layer (Ferro_{f}), and a spacer (SP) interposed in-between, each of the STT-assisted SOT-MRAM bit cells (CELL) further comprising a SOT layer (SOT) adjacent to the ferromagnetic free layer (Ferro_{f}) and two select transistors (TrN, TrP), a first source line (SL) being, in the MRAM bit cell, connected to a second source line (SLB) through, in this order, a first one (TrN) of the two select transistors, the SOT layer (SOT), and a second one (TrP) of the two select transistors, the first one (TrN) and the second one (TrP) of the two select transistors being respectively an N-type transistor and a P-type transistor.

**2.** An array (ARR) according to claim 1, wherein, for each of the bit cells (CELL), the ferromagnetic pinned layer (Ferroₚ) and the ferromagnetic free layer (Ferro_{f}) each present a perpendicular magnetic anisotropy.

**3.** An array (ARR) according to claim 1 or 2, configured to write a magnetic state of the ferromagnetic free layers (Ferro_{f}) by STT-assisted SOT writing.

**4.** An array (ARR) according to any one of claim 1 to 3, wherein, for each of the bit cells (CELL), the tri-layer element (TLE) is a magnetic tunnel junction.

**5.** An array (ARR) according to any one of claim 1 to 3, wherein, for each of the bit cells (CELL), the tri-layer element (TLE) is a spin valve.

**5.** An array (ARR) according to claim 1 or claim 2, wherein each of the bit cells (CELL) further comprises a first word line (WLN) and a second word line (WLP), respectively connected to a gate electrode of the first one (TrN) and the second one (TrP) of the two select transistors, the first word line (WLN) being distinct from the second word line (WLP).

**6.** An MRAM memory (MEM) comprising at least the array (ARR) according to claim 5, a first word line driver (WLN-Drv) functionally connected to the first word line (WLN) so as to drive the first one (TrN) of the two select transistors of bit cells belonging to a same row of bit cells (CELL) of the array (ARR), and a second word line driver (WLP-Drv) functionally connected to the second word line (WLP) so as to drive the second one (TrP) of the two select transistors of the bit cells belonging to the same row of bit cells (CELL) of the array (ARR).

**7.** An MRAM memory (MEM) according to claim 6, wherein the first word line driver (WLN-Drv) is configured to drive the first one (TrN) of the two select transistors by applying a high electrical potential to the first word line (WLN), and the second word line driver (WLP-Drv) is configured to drive the second one (TrP) of the two select transistors by applying a low electrical potential to the second word line (WLP), the low electrical potential being lower than the high electrical potential.

**8.** An MRAM memory (MEM) according to claim 7, wherein the first word line driver (WLN-Drv) and the second word line driver (WLP-Drv) are configured to apply simultaneously the high electrical potential and the low electrical potential respectively to the first word line (WLN) and to the second word line (WLP) to select at least one of the bit cells (CELL) of the array (ARR).

**9.** An MRAM memory (MEM) according to any one of claims 6 to 8, further comprising a bit line driver (BL-Drv) and a source line driver (SL-Drv), the bit line driver (BL-DrV), the source line driver (SL-Drv), the first word line driver (WLN-Drv) and the second word line driver (WLP-Drv) being configured to, during a writing operation of a given one of the bit cells (CELL), circulate a writing current (Iw) between the first source line (SL) and the second source line (SLB) through the channels of the two select transistors and through the SOT line, and circulate a write-assisting current (I_{W-Ass}) through the ferromagnetic pinned layer (Ferroₚ), the spacer (SP) and the ferromagnetic free layer (Ferro_{f}) of the tri-layer element (TLE), thereby writing a magnetic state of the ferromagnetic free layer (Ferro_{f}).

**10.** An MRAM memory (MEM) according to any one of claims 6 to 9, wherein two transistors of a same type (NMOSⱼ, NMOSⱼ₊₁) of two bit cells belonging to two consecutive columns and to the same row of the array (ARR) share a same gate electrode (GNli, GN2i).

**11.** An MRAM memory (MEM) according to any one of claims 6 to 10, wherein four transistors of a same type of four bit cells belonging to four consecutive columns and to the same row of the array (ARR) share a same gate electrode (GP2ᵢ, GP1ᵢ).

**12.** An MRAM memory (MEM) according to any one of claims 6 to 10, wherein a same gate electrode (GP2ᵢ, GP1ᵢ) crosses four regions (PMOSⱼ, PMOSⱼ₊₁, PMOSⱼ₊₂, PMOSⱼ₊₃) each implanted with ions so as to form the source, drain and channel regions of four transistors of a same type.

**13.** An MRAM memory (MEM) according to any one of claims 6 to 12, wherein each of the bit cells (CELL) comprises a plurality of tri-layer elements (TLE) each connected between a respective bit line (BL₀, BL₁, BLₓ) and the SOT layer (SOT).

**14.** An integrated electronic circuit (CHP, CRT) including the MRAM memory (MEM) according to any one of claims 6 to 13.
